(19) Europäisches Patentamt
European Patent Office
Office européen des brevets

(11) **EP 3 136 434 A1**

(12) **EUROPEAN PATENT APPLICATION**

(43) Date of publication:
**01.03.2017 Bulletin 2017/09**

(21) Application number: **15182473.7**

(22) Date of filing: **26.08.2015**

(51) Int Cl.:
***H01L 23/373*** *(2006.01)* ***H01L 23/42*** *(2006.01)*
***H01L 23/467*** *(2006.01)* ***H01L 23/473*** *(2006.01)*
*B82Y 30/00 (2011.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **ETH Zurich**
**8092 Zurich (CH)**

(72) Inventors:
- **KOUMOUTSAKOS, Petros**
  **8126 Zumikon (CH)**
- **CHEN, Jie**
  **8052 Zürich (CH)**
- **WALTHER, Jens Honoré**
  **8002 Zürich (CH)**

(54) **THERMAL INTERFACE ELEMENT**

(57) A thermal interface element (200) comprising a thermal interface material (100) and a circulating fluid (4). The thermal interface material (100) comprises a first graphene sheet (1), a second graphene sheet (2), and an array of carbon nanotubes (3). The array of carbon nanotubes (3) is arranged between the first graphene sheet (1) and the second graphene sheet (2), such that the carbon nanotubes of the array (3) are in thermal contact with the first graphene sheet (1) and the second graphene sheet (2). The circulating fluid (4) is in fluid communication with the array of carbon nanotubes (3).

2
21
D
100
L
c
3
11
1

Fig. 1

EP 3 136 434 A1

## Description

The present invention relates to the use of a thermal interface element as a heat-exchanger and the thermal interface element itself.

Heat dissipation can drastically limit the performance and reliability of microelectronic devices. Therefore, thermal management has become a critical aspect for designing integrated circuits. One of the challenges of heat exchanger systems for cooling of such devices is thereby to efficiently transfer heat between a surface of the device and the environment.

One approach to dissipate heat from a microelectronic device is the use of a heat sink, which is a passive heat exchanger that cools down a device by dissipating heat to the surrounding environment. To achieve good thermal contact between a hot surface of such a device and a surface of the heat sink, thermal interface materials (TIMs) are applied. TIMs are materials with high thermal conductivity and the ability to establish good contact with a specific surface, such as described for example in Prasher, R. Proc. IEEE, 94, 1571 (2006). Such TIMs can have different compositions, e.g. they can comprise conductive paste or metallic foil.

With the increasing packaging density of microelectronic devices, thermal management has become an even more critical aspect. Today, power density on a modern microprocessor can reach 100 W/cm$^2$, requiring novel types of cooling concepts and thus novel types of TIMs, since conventional TIMs are not efficiently enough for such devices. Furthermore, as the next generation of integrated circuits is expected to rely on 3D chip stacking, novel solutions are required for cooling such stacks. Conventional approaches for dissipating heat, such as the use of conventional TIMs, no longer suffice the high requirements for the heat management of such devices.

Thus, it is an object of the present invention to mitigate at least some of these drawbacks of the state of the art. In particular, it is an aim of the present invention to provide a thermal interface element for fast and high efficient exchange of heat with a surface.

These objectives are achieved by a thermal interface element comprising a thermal interface material and a circulating fluid. The thermal interface material comprises a first graphene sheet, a second graphene sheet and an array of carbon nanotubes. Preferably, the first graphene sheet is arranged at a bottom side of the thermal interface element, wherein it is in laminar contact with a device surface, and the second graphene sheet is arranged at a top side of the thermal interface element, facing away from the device surface. The array of carbon nanotubes, preferably comprising at least two carbon nanotubes, is arranged between the first graphene sheet and the second graphene sheet, such that the carbon nanotubes of the array are in thermal contact with the first graphene sheet and with the second graphene sheet. Thereby, preferably a first end of the carbon nanotubes of the array is in thermal contact with the first graphene sheet and a second end of the carbon nanotubes is in thermal contact with the second graphene sheet. Being in thermal contact relates to the ability of the carbon nanotube and the graphene layer to exchange thermal energy with each other. Preferably, such thermal contact is established by covalent bonds. Thereby, in a preferred embodiment of the present invention, a first end of each carbon nanotube of the array is covalently bonded to the first graphene sheet and/or a second end of each carbon nanotube of the array is covalently bonded to the second graphene sheet. These covalent bonds are established by carbon-carbon bonds at one or more junctions between each carbon nanotube of the array and the first and/or second graphene sheets. The junction between each carbon nanotube of the array and the first and/or second graphene sheet may be seamless, meaning that each carbon nanotube of the array connects to the first and/or second graphene sheet around a perimeter of the open carbon nanotube, thereby forming a hole into the first and/or second graphene sheet, wherein the hole has the size of the diameter of the particular carbon nanotube of the array. A hollow area of the first graphene sheet is then defined to be an area which adds up the areas of all holes formed by the respective array of carbon nanotubes.

Preferably, the carbon-carbon junctions between the first and/or second graphene sheet and the carbon nanotubes of the array are established by means of sp$^2$ hybridized carbon atoms of the first and/or second graphene sheet and by means of hybridized carbon atoms of the carbon nanotubes of the array. The sp$^2$ covalent bonding at the graphene/carbon nanotube junctions saturates all dangling bonds, e.g. by forming hexagons and heptagons, and thus gives rise to a seamless connection between the graphene sheet and each carbon nanotube of the array.

The carbon nanotubes of the array are preferably single-walled carbon nanotubes, meaning that they comprise a single carbon layer, and have a preferred diameter of bellow 10nm, very preferably of bellow 5nm. A length of the carbon nanotubes of the array relates to a length along the longitudinal axis of the carbon nanotubes of the array and is preferably within a range of 10nm to 10$\mu$m, very preferably within a range from the order of 10nm to the order of 10$\mu$m. The length of the carbon nanotubes of the array defines preferably also the distance between the first graphene sheet and the second graphene sheet. In such a preferred embodiment, the first and the second graphene sheet are arranged parallel to each other, wherein the distance is defined by the length of the carbon nanotubes of the array, wherein the carbon nanotubes can be arranged orthogonally to the first and to the second graphene sheet. Preferably, the carbon nanotubes of the array are thereby of equal length.

The small dimensions of the thermal interface material make it a promising material for microscale applications. Without being bond to theory, it is assumed that the thermal interface material possess high thermal conductivity vertically to the first graphene sheet, in a so called c-axis, due to its hybrid properties of graphene and carbon nanotubes. Carbon nanotubes provide efficient heat transfer along their longitudinal axis. But if carbon nanotubes alone are contacting a surface, e.g. the surface selected from a microelectronic element, a chip, or a chip stack, the small diameter of the carbon nanotubes results in a large thermal contact resistance, meaning that the heat flow is restricted at these contacts, that dominates the overall thermal resistance.

In contrast, the first and/or second graphene sheet provides a large contact area to mediate heat transfer from the surface and/or from a further surface respectively. While graphene has a superior in-plane thermal conductivity, its cross-plane heat transfer, that is the heat transfer vertically to the graphene plane in the c-axis, from a first graphene sheet to a second graphene sheet in few-layer graphene, is hindered by a large inter-layer thermal resistance. Hence, the hybrid thermal interface material described herein drastically reduces the inter-layer thermal resistance in the c-axis between the first and the second graphene sheet.

Without being bound to theory, it is believed, that the reduction of the inter-layer thermal resistance of the thermal interface material can be explained as following: Thermal transport can be explained by investigating the energy transmission of phonon wave packets, in particular for the acoustic, in the thermal interface material. If a carbon nanotube of the array is covalently bonded to the first graphene sheet, an acoustic phonon wave packet is propagating from the first graphene sheet through the carbon nanotube of the array to the second graphene sheet. One of the acoustic phonon modes in the first graphene sheet is equivalent to an acoustic phonon mode of a carbon nanotube of the array. The activation of this acoustic phonon mode in the first graphene sheet activates the acoustic phonon mode with the same wavenumber in the carbon nanotube and therefore results in a lower thermal resistance at an interface between the first graphene sheet and the carbon nanotube of the array compared to an interface of a few-layer graphene material.

In preferred embodiments of the invention, which will be discussed in detail below, this advantageous effect leads to thermal resistances of below $1.6 \times 10^{-10}$ $m^2K/W$, very preferably of below $0.02 \times 10^{-10}$ $m^2K/W$ for the thermal interface material.

To characterize the arrangement of the carbon nanotubes of the array, a density of the thermal interface material can be defined. The density of the thermal interface material relates to the percentage of an area of the first graphene sheet, which is bonded to the carbon nanotubes of the array. Such density $\rho$ can be calculated by a formula (I)

$$\rho = N*\pi*(D/2)^2/S_0 \qquad (I)$$

wherein N represents a number of carbon nanotubes of the array, D represents the diameter of the carbon nanotubes, and $S_0$ represents the cross section of the first graphene sheet including the hollow area.

Without being bound to theory, it is believed that if a density of the thermal interface material is in a low density region of below 20% ($\rho$ < 20%), a distance between the carbon nanotubes of the array $d_{min}$ is larger than a Lennard-Jones interaction parameter $\sigma$ ($d_{min} > 3\sigma$). Preferably, the distance is several times larger than the interaction parameter $\sigma$, in particular two to five times larger. The Lennard-Jones interaction parameter is defined to be a parameter of the Lennard-Jones potential equation, wherein $\sigma$ is a distance, for which the Lennard-Jones potential reaches a value of zero. If the distance $d_{min}$ is larger than the Lennard-Jones interaction parameter ($d_{min} > 3\sigma$), the Lennard-Jones interaction between the individual carbon nanotubes of the array is negligible and therefore the thermal conductivity of the thermal interface material is independent of the specific arrangement of the carbon nanotubes of the array. Within a low density region of below 5%, the thermal conductivity of the thermal interface material increases linearly with the density $\rho$. For a density above 20% ($\rho$ > 20%), the Lennard-Jones interaction can no longer be neglected and the individual carbon nanotubes of the array experience enhanced phonon scattering. The phonon scattering impairs the thermal conductivity of the material.

Therefore, in a preferred embodiment of the invention, the carbon nanotubes of the array, which bond to the first graphene sheet, cover less than 20% of the area of the graphene sheet. Very preferably is a density of equally or below 10%.

The thermal conductivity of each carbon nanotube of the array depends further on the length of the carbon nanotubes. Thermal conductivity of the carbon nanotubes is increasing with increasing length at the nanoscale. The thermal conductivity is supposed to be sublinearly dependent on the length "$L_i$" of the particular carbon nanotube. Therefore, a thermal interface material comprising an array of carbon nanotubes, wherein the carbon nanotubes have a certain length "$L_i$", has a higher thermal conductivity than a material comprising a single carbon nanotube with an equivalent total length $L_{tot}$

$$(Ltot = \sum_{i=1}^{i=N} L_i)\ .$$

This dependence is in particular advantageous, if the space for the thermal interface material is limited. The thermal conductivity and thus also the efficiency of the thermal interface material can therefore be enhanced by increasing the density of carbon nanotubes of the array up to 20% or by increasing the length of the carbon nanotubes of the array up to the order of 10$\mu$m.

Regarding the chemical structure of the thermal interface material, graphene as well as carbon nanotubes are allotropes of carbon. Graphene has 2-dimensional properties, wherein its carbon atoms are densely packed in a regular hexagonal pattern. Carbon nanotubes have a cylindrical nanostructure with a long hollow structure and the walls formed by one-atom-thick sheets of carbon. The so-called chirality of the carbon nanotubes describes the different types which carbon nanotubes can form. To distinguish the different types, a chiral vector R(n, m) in a hexagonal lattice is defined. The hexagonal lattice origins from the arrangement of the carbon atoms in the nanotube. The variables "n" and "m" denote the number of unit vectors along two directions of the hexagonal lattice. The chiral vector has a vector equation of a formula (II)

$$R\ (n,\ m) = na_1 + ma_2 \qquad (II),$$

using the vectors a1 and a2 for a unit cell of the hexagonal lattice. In the present invention, the carbon nanotubes of the array preferably are of a so-called armchair type with a chiral vector R (n, m=n). Further embodiments of the present invention include different chiral types of carbon nanotubes, e.g. such of zigzag type with a chiral vector R (n, 0).

A preferred embodiment of the invention comprises a thermal interface material with a density $\rho$ of around 10% and with the carbon nanotubes of the array having a length of L $\approx$ 16nm. The c-axis thermal conductivity of such a preferred thermal interface material reaches low thermal resistances of equal or below $1.6\times10^{-10}m^2K/W$. In a further preferred embodiment the invention comprises a thermal interface material with a density $\rho$ of around 10% and with the carbon nanotubes of the array having a length of L $\approx$ 10$\mu$m. The c-axis thermal conductivity of such a further preferred thermal interface material reaches low thermal resistances of equal or below $0.02\times10^{-10}\ m^2K/W$.

In a further embodiment, the thermal interface material can comprise a vertically stacked structure. Thereby, the thermal interface material comprises a third graphene sheet, which is arranged adjacent to the second graphene sheet, in particular above the second graphene sheet. The carbon nanotubes of a second array are arranged between the second graphene sheet and the third graphene sheet, wherein a first end of each carbon nanotube of the second array is covalently bonded via carbon-carbon bonds to the second graphene sheet, and/or wherein a second end of each carbon nanotube of the second array is covalently bonded via carbon-carbon bonds to the third graphene sheet. The circulating fluid is preferably in fluid communication with the array and the second array of carbon nanotubes. The carbon nanotubes of the array and of the second array thereby emanate both from the second graphene sheet, in particular in opposite directions, but without overlapping. The arrangement of the carbon nanotubes in the second array is preferably different from the arrangement of the carbon nanotubes in the array, but can be flexible, as long as there is no overlapping in the position of the carbon nanotubes from the array and the second array. For this embodiment, if integrated into a device, the third graphene sheet could be in contact with the further surface, equivalently to the second graphene sheet.

In further embodiments, the thermal interface material could comprise multiple graphene sheets, e.g. a fourth, a fifth, or more graphene sheets arranged accordingly, wherein further arrays of carbon nanotubes would be arranged between the more graphene sheets, preferably stacked on top of each other. The fourth, fifth, or a further graphene sheet could thereby be in contact with a further surface, equivalently to the second graphene sheet. It might be advantageous, to fabricate a thermal interface material with multiple graphene sheets for manufacturing reasons.

In addition to the thermal interface material, the thermal interface element comprises further a circulating fluid, which is in fluid communication with the array of carbon nanotubes. Being in fluid communication relates to the array of carbon nanotubes being in contact with the circulating fluid. The circulating fluid can further be in contact with the first graphene sheet and/or the second graphene sheet and/or the third graphene sheet. Preferably, a gap between the first graphene sheet and the second graphene sheet serves as a passage for the circulating fluid. The circulating fluid is preferably selected from liquids and/or gases. Liquids are preferably selected from water, aqueous solutions, polar organic solvents, e.g. alcohols, glycols, and cyclic esters, and non-polar solvents, e.g. aromatics and hydrocarbons. Gases are preferably selected from air and $N_2$.

Preferably, the circulating fluid is flowing through the gap between the first graphene sheet and the second graphene sheet and thereby exchanging thermal energy with the thermal interface material. In a preferred embodiment of the invention, the circulating fluid flows through the gap and thereby forces convection of the thermal interface structure for transferring heat e.g. to cool down the thermal interface material.

The thermal interface element is part of a heat exchange system further comprising a surface. The surface is in thermal contact with the first graphene sheet, e.g. by associating the first graphene sheet with the substrate or with portions of the substrate. Being in thermal contact with the surface relates to the exchange of heat between the first graphene sheet and the surface. Preferably, the heat exchange system comprises a further surface, which further surface is in thermal contact with the second graphene sheet. Furthermore, the thermal contact can be established by associating the second graphene sheet with the further substrate or with portions of the further substrate. The surface and the further surface may be any surface to be heated or cooled in part and/or may be each surface or a portion of a surface, e.g. selected from a microelectronic element, a chip with an integrated circuit, an oxide, a heat sink, a packaging element, a sensor, and a membrane.

The heat exchange system can be used for cooling the surface and/or the further surface. Since the surface and/or the further surface is in thermal contact with the first graphene sheet and/or the second graphene sheet respectively, heat is transferred from the surface and/or the further surface to the thermal interface material and from there to the circulating fluid. Cooling of the surface and/or the further surface occurs in two steps. First, the temperature of the surface and/or the further surface is reduced by applying the thermal interface material irrespective of the presence of the fluid. The thermal interface material is cooling the surface ultrafast and thereby the temperature of the surface is rapidly reduced (within picoseconds). Second, the heat is transferred from the thermal interface material to the circulating fluid and is transferred with the fluid away from the thermal interface material and therefore away from the surface and/or the further surface.

Thermal transport in the heat exchange systems can occur in vertical and in horizontal direction with respect to the surface of the first graphene sheet. For instance, the system can be applied for cooling hot spots on a chip with a heat sink by vertical and horizontal heat transfer. In this case, the system comprises the surface of the chip, the thermal interface element, and the further surface of the heat sink. The heat is transported from the chip surface to the first graphene sheet and thereby to the thermal interface material and the circulating fluid. The heat transfer from the first graphene sheet to the heat sink occurs in vertical direction, wherein some of the heat is removed in horizontal direction by the circulating fluid. In another example, the heat is transferred parallel to the first graphene sheet, e.g. for transferring heat within a three dimensional chip stack, for cooling hot-spots of chips within the stack. Thereby, the heat exchange system comprises the surface from a level of stacked chips, the thermal interface element, and the further surface of a further level of stacked chips. Heat from the surface is transferred to the first graphene sheet and heat from the further surface is transferred to the second graphene sheet and thereby is transferred from the two surfaces to the thermal interface element. The circulating fluid is transferring the heat away from the element, such that a horizontal heat transfer away from the surfaces and cooling of the chip stack occurs.

The low thermal resistance and therefore high thermal conductivity of the thermal interface element enables sufficient cooling of the surface, which is preferably in laminar contact with the first graphene sheet, and/or the further surface, which is preferably in laminar contact with the second graphene sheet.

The fabrication of the thermal interface material is known. For instance, US 2012/0152725 A1 describes a method for fabricating pillared graphene by assembling alternate layers of graphene sheets and fullerenes to form a stable material. The document, specifically paragraphs [0007] to [0010], are hereby incorporated by reference. Single graphene layers may be made in various ways, e.g. by epitaxial growth by chemical vapour deposition or ion implantation or by supercritical fluid delamination from graphite. Spherical fullerenes, so called buckyballs, are molecules which are entirely composed of $sp^2$ bonded carbon atoms, densely packed in a crystal lattice taking the form of a hollow sphere. Buckyballs can have different sizes relating to different amounts of carbon atoms. The most common size is a $C_{60}$ buckyball, comprising 60 carbon atoms.

Preferably, the thermal interface material is therefore fabricated by first constraining a layer of spherical fullerenes between a first graphene sheet and a second graphene sheet to form a pre-material. The fullerenes may be chemically bonded to the graphene by binding molecules. Energy is applied to the pre-material via chemical reaction, thermal or radiative processes to break the carbon-carbon double bonds and open holes in the fullerenes and the first and the second graphene sheets at the binding points. The fullerenes and the first and the second graphene sheets near the binding points reorganize their carbon-carbon bonds via cycloadditional reactions resulting in the establishment of fullerene-to-graphene sheet bonds around the perimeter of the holes and reorganization of their carbon-carbon bonds to form open nanotubes that are conjoined between the first and the second graphene sheet in the thermal interface material. The same principle may be used to fabricate further embodiments of the thermal interface material, e.g. for materials which comprise more than two graphene sheets. In a further embodiment of the thermal interface material, the first and/or the second graphene sheet and/or the spherical fullerenes may be doped with a variety of dopants. The spherical fullerenes, which are used for fabricating the thermal interface material are preferably of a uniform type to ensure a uniform spacing between the first and the second graphene sheet. The density of the thermal interface material can be determined by assembling the fullerenes on the first graphene sheet, e.g. manually with a specific tool, such as an atomic force microscope or a scanning electron microscope or by a self-assembly process.

To associate the first and/or second graphene sheet with the surface and/or further surface respectively, the graphene film can be fabricated by chemical vapour deposition onto the surface and/or further surface. In a further embodiment, the first and/or second graphene sheet can become associated with the substrate and/or the further substrate by transferring a pre-grown graphene film onto the substrate and/or the further substrate. The thermal interface material can be fabricated before applying it to the surface and/or further surface or can be fabricated directly onto the surface and/or onto the further surface.

The various embodiments, preferences and ranges as provided/disclosed may be combined at will.

Other advantageous embodiments are listed in the dependent claims as well as in the description below.

As used herein, the terms "including", and "comprising" are used herein in their open, non-limiting sense. The term "a", "an", "the", and similar terms used in the context of the present invention are to be construed to cover both the singular and plural unless otherwise indicated herein or clearly contradicted by the context.

Brief Description of the Drawings

Embodiments of the present invention, aspects, and advantages will become apparent from the following detailed description thereof. Such description makes reference to the annexed drawings, wherein the figures show:

Fig. 1 shows a stick model of a portion of a thermal interface material according to an embodiment of the present invention,
Fig. 2 shows a space-filling model of a portion of a thermal interface element according to an embodiment of the present invention,
Fig. 3 shows a schematic of a portion of a heat exchange system according to an embodiment of the present invention, and
Fig. 4 shows a schematic of a portion of a heat exchange system with a further surface according to an embodiment of the present invention, and
Fig. 5 shows a stick model of a portion of a thermal interface material according to another embodiment of the present invention.

Modes for Carrying Out the Invention

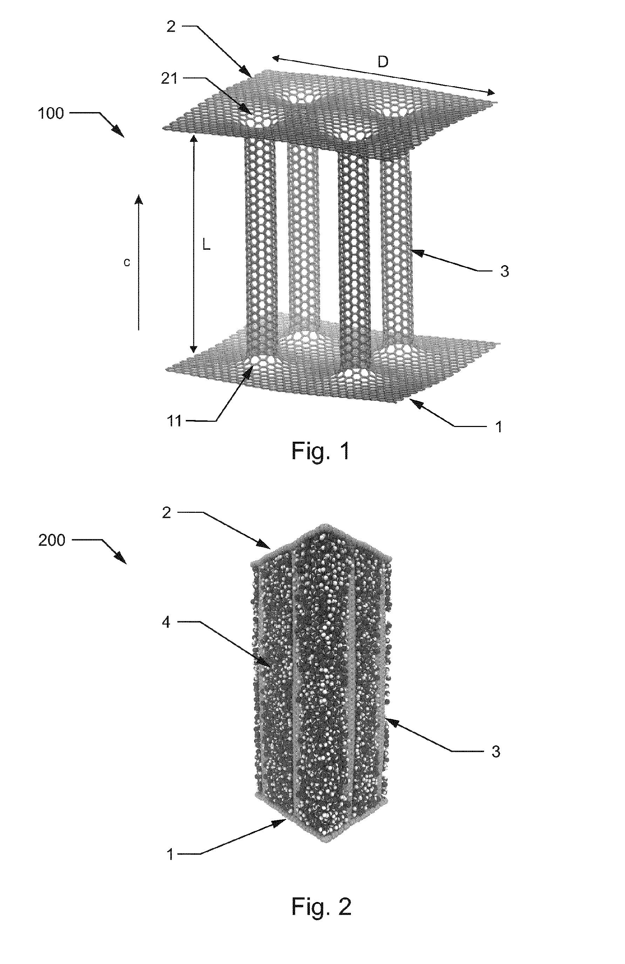

Figure 1 shows an idealized structure of a portion of a preferred embodiment of the thermal interface material 100 comprising a first graphene sheet 1, a second graphene sheet 2, and an array of carbon nanotubes 3, which is arranged between the first graphene sheet 1 and the second graphene sheet 2. The carbon nanotubes of the array 3 are in thermal contact with the first graphene sheet 1 and the second graphene sheet 2. Thermal contact is established by a first end of the carbon nanotubes, which are in thermal contact with the first graphene sheet 1, and a second end of the carbon nanotubes, which are in thermal contact with the second graphene sheet 2. The first end of each carbon nanotube of the array 3 is covalently bonded via carbon-carbon bonds to the first graphene sheet 1. The second end of each carbon nanotube of the array 3 is covalently bonded via carbon-carbon bonds to the second graphene sheet 2. Figure 1 shows only a representative element of the thermal interface material 100. The array of carbon nanotubes 3 typically comprises more than the shown four carbon nanotubes. The carbon nanotubes of the array 3 can further be distributed between the first graphene sheet 1 and the second graphene sheet 2 in a regular pattern as shown in the Figure, but they can also be distributed randomly. The carbon nanotubes of the array 3 emanate from the first graphene sheet 1 such that the first end of each carbon nanotube of the array 3 forms a hole 11 into the first graphene sheet 1 at the point where they bind to the first graphene sheet 1. The second ends of the carbon nanotubes of the array 3 emanate from the second graphene sheet 2, wherein they form a second hole 21 at the point where they bind to the second graphene sheet 2. A c-axis thermal conductivity of the thermal interface material is indicated by the arrow c.

Figure 2 illustrates an idealized portion of a preferred embodiment of a thermal interface element 200, which comprises the thermal interface material 100 and a circulating fluid 4. The circulating fluid 4 is in fluid communication with the carbon nanotubes of the array 3. The circulating fluid 4 is flowing through the gap between the first graphene sheet 1 and the second graphene sheet 2. Thereby, the circulating fluid 4 exchanges heat with the carbon nanotubes of the array 3 and/or with the first graphene sheet 1 and/or with the second graphene sheet 2. The circulating fluid 4 can thereby cool down or heat up the array of carbon nanotubes 3, the first graphene sheet 1, and the second graphene sheet 2. Preferably, the circulating fluid 4 is cooling down the thermal interface material 100 by flowing through the material, exchanging heat with the material 100 and transporting the heat away from the material 100. As shown in the schematic Figure, the circulating fluid is preferably water.

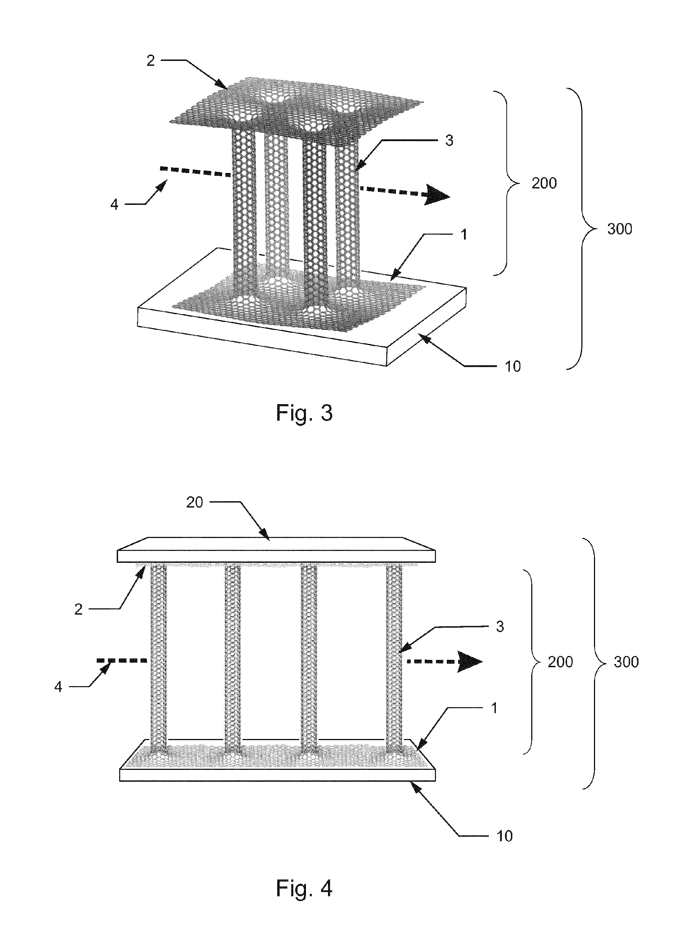

Figure 3 illustrates a portion of a preferred embodiment of a heat exchange system 300. The heat exchange system 300 comprises a thermal interface element 200 and a surface 10, which surface 10 is in thermal contact with the first graphene sheet 1. The thermal interface element 200 can thereby be in contact with only a portion of the surface 10 as shown in the Figure, but it can also be in contact with the whole surface 10. Contact between the surface 10 and the first graphene sheet 1 can be established by associating the two with each other. An arrow 4 indicates a flowing direction of the circulating fluid 4 of the thermal interface element 200. The surface 10 can be cooled down or heated up with the thermal interface element 200. Preferably, the surface 10 is cooled down, by exchanging heat with the first graphene sheet 1, which heat is transferred to the carbon nanotubes of the array 3 due to low thermal resistance at an interface between the first graphene sheet 1 and the carbon nanotubes of the array 3. The circulating fluid 4 is exchanging heat with the carbon nanotubes of the array 3 and with the first graphene sheet 1. Thereby, the thermal interface material 100 is cooled down and the circulating fluid 4 is heating up. Since the fluid 4 is circulating, the heated portion of the fluid 4 is transported away from the thermal interface material 100.

Figure 4 shows a portion of a further preferred embodiment of a heat exchange system 300. The heat exchange system 300 thereby not only comprises the first surface 10, but also a further surface 20. The further surface 20 is in thermal contact with the second graphene sheet 2. The further surface 20 can thereby be associated with the second graphene sheet 2. The surface 10 and/or the further surface 20 can thereby be surfaces and/or portion of surfaces of a semiconductor device, a microelectronic device, an oxide, a heat sink, a sensor, a membrane, or a chip. In particular, the surface 10 and the further surface 20 can be surfaces of a stack of chips, wherein the heat exchanger system 300 is arranged in between two levels of such a stack. The thermal interface material 100 is a mechanically strong structure due to the strength of the carbon nanotubes of the array 3 even in longitudinal direction. Therefore, the heat exchange system 300 could even withstand forces in longitudinal direction of the carbon nanotubes of the array 3, as they might occur if the heat exchange system 300 is arranged within a stacked device.

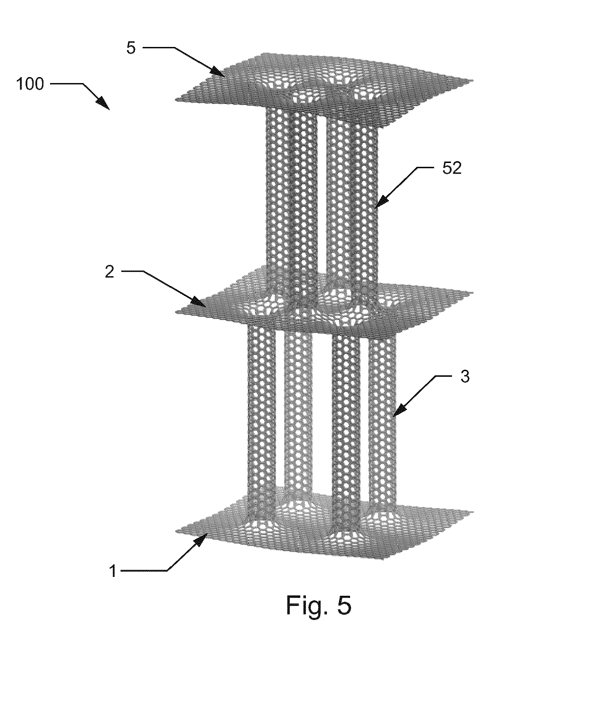

Figure 5 illustrates an idealized portion of a further embodiment of the thermal interface material 100. Thereby, the thermal interface material 100 comprises a first graphene sheet 1, a second graphene sheet 2, and a third graphene sheet 5, which third graphene sheet 5 is arranged adjacent to the second graphene sheet 2. The carbon nanotubes of the array 3 are in thermal contact with the first graphene sheet 1 and with the second graphene sheet 2, wherein a first end of each carbon nanotube of the array 3 is preferably covalently bonded to the first graphene sheet 1 and a second end of each carbon nanotube of the array 3 is preferably covalently bonded to the second graphene sheet 2. A second array 52 of carbon nanotubes is arranged between the second graphene sheet 2 and the third graphene sheet 5. The carbon nanotubes of the second array 52 are in thermal contact with the second graphene sheet 2 and with the third graphene sheet 5. A first end of each carbon nanotube of the second array 52 is covalently bonded via carbon-carbon bonds to the second graphene sheet 2 and a second end of each carbon nanotube of the second array 52 is covalently bonded via carbon-carbon bonds to the third graphene sheet 3. The carbon nanotubes of the array 3 and of the second array 52 thereby emanate both from the second graphene sheet 2, in particular in opposite directions but without overlapping. The arrangement of carbon nanotubes in the second array 52 can be flexible, just to avoid the overlapping in the carbon nanotube positions with the array 3. Not shown in Figure 5 are further possible embodiments, wherein the thermal interface material comprises further stacks of graphene sheets and arrays of carbon nanotubes, which stacks are similarly arranged adjacent to the second graphene sheet 2 and which stacks are in fluid communication with the circulating fluid 4.

While there are shown and described presently preferred embodiments of the invention, it is to be distinctly understood that the invention is not limited thereto but may be otherwise variously embodied and practised within the scope of the following claims.

## Claims

**1.** A thermal interface element (200) comprising a thermal interface material (100) and a circulating fluid (4), wherein the thermal interface material (100) comprises

- a first graphene sheet (1),
- a second graphene sheet (2), and
- an array of carbon nanotubes (3), which is arranged between the first graphene sheet (1) and the second graphene sheet (2),

wherein a first end of each carbon nanotube of the array (3) is covalently bonded via carbon-carbon bonds to the first graphene sheet (1), and/or wherein a second end of each carbon nanotube of the array (3) is covalently bonded via carbon-carbon bonds to the second graphene sheet (2), and wherein the circulating fluid (4) is in fluid communication with the array of carbon nanotubes (3).

**2.** The thermal interface element (200) according to claim 1, wherein for the thermal interface material (100):

- the first graphene sheet (1) and the second graphene sheet (2) are arranged in parallel, and/or
- a longitudinal axis of the carbon nanotubes of the array (3) is arranged orthogonally to the first (1) graphene sheet and to the second graphene sheet (2), and/or
- the carbon nanotubes of the array (3) are of equal length.

**3.** The thermal interface element (200) according to any one of the previous claims, wherein for the thermal interface material (100):

- the carbon nanotubes of the array (3) are single-walled carbon nanotubes, and/or
- have a diameter of below 10nm, very preferably below 5 nm, and/or
- have a length along their longitudinal axis from 10nm to 10μm, and/or
- are armchair carbon nanotubes with a chiral vector (n, n).

**4.** The thermal interface element (200) according to any one of the previous claims, wherein for the thermal interface material (100):

- a density p, which is a percentage of an area of the first graphene sheet (1) bonded to the carbon nanotubes of the array (3), is below 20%, preferably equal or below 10%, very preferably below 5%, and/or

- a c-axis thermal resistance is below $1.6\times10^{-10}$ $m^2K/W$, very preferably below $0.02\times10^{-10}$ $m^2K/W$.

**5.** The thermal interface element (200) according to any one of the previous claims, wherein for the thermal interface material (100),
the minimum distance between the carbon nanotubes of the array (3) is at least two times, preferably three to five times, larger than a Lennard-Jones interaction parameter $\sigma$.

**6.** The thermal interface element (200) according to any one of the previous claims, wherein the circulating fluid (4) is selected from

- liquids, such as
  - water and aqueous solutions,
  - polar organic solvents, preferably alcohols, glycols, and cyclic esters, and
  - non-polar organic solvents, preferably aromatics and hydrocarbons, and/or
- gases, such as air and $N_2$.

**7.** The thermal interface element (200) according to any one of the previous claims, wherein for the thermal interface material (100),
each carbon nanotube of the array (3) connects to the first graphene sheet (1) and/or to the second graphene sheet (2) around a perimeter of the carbon nanotube, thereby forming a hole (11, 21) into the first graphene sheet (1) and/or into the second graphene sheet (2).

**8.** The thermal interface element (200) according to any one of the previous claims,
wherein the thermal interface material (100) comprises a third graphene sheet (5), which is arranged adjacent to the second graphene sheet (2),
wherein carbon nanotubes of a second array (52) are arranged between the second graphene sheet (2) and the third graphene sheet (5),
wherein a first end of each carbon nanotube of the second array (52) is covalently bonded via carbon-carbon bonds to the second graphene sheet (2), and/or
wherein a second end of each carbon nanotube of the second array (52) is covalently bonded via carbon-carbon bonds to the third graphene sheet (5), and
wherein the circulating fluid (4) is in fluid communication with the second array (52) of carbon nanotubes.

**9.** A heat exchange system 300, comprising the thermal interface element (200) according to any one of claims 1 to 8 and a surface (10),

- which surface (10) is in thermal contact with the first graphene sheet (1).

**10.** The heat exchange system 300 according to claim 9, comprising

- a further surface (20), which is in thermal contact with the second graphene sheet (2) or a third graphene sheet (5).

**11.** The heat exchange system 300 according to claim 9 or 10,
wherein the surface (10) and/or the further surface (20) are each a surface or a portion of a surface selected from the group consisting of a microelectronic element, a chip with an integrated circuit, an oxide, a three dimensional stack of chips, a heat sink, and a packaging element.

**12.** Use of a thermal interface element (200) according to any one of claims 1 to 8 for cooling a surface (10), in particular wherein the surface (10) is in thermal contact with the first graphene sheet (1).

**13.** Use of a thermal interface element (200) according to claim 12,
wherein the surface (10) is a surface or a portion of a surface selected from the group consisting of a microelectronic element, an oxide, a chip with an integrated circuit, a three dimensional stack of chips, a heat sink, and a packaging element.

**14.** Use of a thermal interface element (200) according to claims 12 or 13 for exchanging heat with a further surface (20),
wherein the second graphene sheet (2) is in thermal contact with the further surface (20).

**15.** Method for cooling a surface (10) comprising the steps of

- providing a thermal interface material (100) according to claim 1,
- bringing a first graphene sheet (1) of that material (100) into thermal contact with the surface (10), and
- bringing a circulating fluid (4) into fluid communication with an array of carbon nanotubes (3) of that thermal interface material (100).

2
D
21
100
L
c
3
11
1

Fig. 1

2
200
4
3
1

Fig. 2

2
3
200
300
4
1
10

Fig. 3

20
2
3
200
300
4
1
10

Fig. 4

5
100
52
2
3
1

Fig. 5

# EUROPEAN SEARCH REPORT

Application Number
EP 15 18 2473

| Category | Citation of document with indication, where appropriate, of relevant passages | Relevant to claim | CLASSIFICATION OF THE APPLICATION (IPC) |
|---|---|---|---|
| A | US 2011/032678 A1 (ALTMAN DAVID H [US] ET AL) 10 February 2011 (2011-02-10)<br>* figures *<br>* paragraph [0010] - paragraph [0016] *<br>* paragraph [0029] - paragraph [0037] *<br>----- | 1-15 | INV.<br>H01L23/373<br>H01L23/42<br>H01L23/467<br>H01L23/473 |
| A | US 2014/127584 A1 (KIM YOUN-SU [US] ET AL) 8 May 2014 (2014-05-08)<br>* figures *<br>* paragraph [0002] *<br>* paragraph [0011] - paragraph [0012] *<br>----- | 1-15 | ADD.<br>B82Y30/00 |

TECHNICAL FIELDS SEARCHED (IPC)

H01L
B82B
C01B

The present search report has been drawn up for all claims

| Place of search | Date of completion of the search | Examiner |
|---|---|---|
| The Hague | 10 February 2016 | Hofer-Weissenfels, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 15 18 2473

This annex lists the patent family members relating to the patent documents cited in the above-mentioned European search report. The members are as contained in the European Patent Office EDP file on The European Patent Office is in no way liable for these particulars which are merely given for the purpose of information.

10-02-2016

| Patent document cited in search report | Publication date | Patent family member(s) | Publication date |
|---|---|---|---|
| US 2011032678 A1 | 10-02-2011 | EP 2462613 A1 | 13-06-2012 |
| | | JP 5628312 B2 | 19-11-2014 |
| | | JP 2013501379 A | 10-01-2013 |
| | | US 2011032678 A1 | 10-02-2011 |
| | | US 2012094484 A1 | 19-04-2012 |
| | | WO 2011017136 A1 | 10-02-2011 |
| US 2014127584 A1 | 08-05-2014 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20120152725 A1

### Non-patent literature cited in the description

- **PRASHER, R.** *Proc. IEEE,* 2006, vol. 94, 1571